# EUROPÄISCHE PATENTSCHRIFT

(11) **EP 0 330 831 B1**
(45) Veröffentlichungstag und Bekanntmachung des Hinweises auf die Patenterteilung: **04.10.1995**
(21) Anmeldenummer: 89101086.0
(22) Anmeldetag: 23.01.1989
(51) Int. Cl.: H01L 21/68, H05K 13/00

(54) **Verfahren und Einrichtung zum Bestücken von metallenen Systemträgern mit elektronischen Komponenten**
Method and device to insert electronic components in metallic support strips
Méthode et dispositif pour insérer des composants électroniques sur des bandes métalliques de support

(30) Priorität: 26.02.1988 CH 722/88; 26.02.1988 CH 723/88
(43) Veröffentlichungstag der Anmeldung: 06.09.1989
(73) Patentinhaber: ESEC SA, CH-6330 Cham/Steinhausen (CH)
(72) Erfinder: Imlig, Martin, CH-6414 Oberarth (CH); Steiger, Andreas, CH-6300 Zug (CH)
(74) Vertreter: EGLI-EUROPEAN PATENT ATTORNEYS

(56) Entgegenhaltungen:
- CH-A- 0 423 397
- US-A- 3 627 190
- US-A- 4 674 670

## Beschreibung

Die Erfindung betrifft ein Verfahren zum Bestücken streifenförmiger Systemträger (Leadframe Strips) mit elektronischen Komponenten gemäss dem Oberbegriff des ersten Patentanspruchs.

Die Erfindung betrifft weiter eine Einrichtung zur Durchführung des Verfahrens.

Bei der Automatisierung von Bewegungs- und Bearbeitungsabläufen, insbesondere in Verbindung mit einer zum Transport relativ dünner (Grössenordnung etwa 0,1 bis etwa 2,0 mm), streifenartiger, metallener Systemträger (Leadframe Strips) entsprechend ausgebildeten Einrichtung, besteht das Problem, dass die einzelnen Systemträger zum Aufbringen elektronischer Komponenten und zur Bindung (zum Bonden) integrierter Schaltkreise mit im µ -Bereich liegenden Toleranzen exakt ausgerichtet und lagestabil einer Bearbeitungs- oder Bondstation oder dergleichen zuzuführen sind.

Aus der US-A-4 674 670 ist eine Bond-Einrichtung zum Befestigen elektronischer Komponenten auf einem Werkstück (Leadframe) bekannt, welche im wesentlichen einen in der Ebene in X- und Y-Richtung bewegbaren und als Tragelement für einen Bondkopf ausgebildeten Tisch umfasst, welcher auf einem Rahmen angeordnet und zur Erreichung der X-und Y-Bewegungen mit einem Motor wirkverbunden ist. Bei dieser Bond-Einrichtung erfolgt die Zuführbewegung des in Schienen geführten Werkstücks (Leadframe) mittels entsprechend angetriebener Förderbänder, wobei die Position des einzelnen Werkstücks in bezug auf den Bondkopf durch ein optisches System in Form einer TV-Kamera überwacht wird. Die einzelnen Systemträger werden auf ein umlaufend angetriebenes Förderband gelegt und im wesentlichen durch Reibung dem Bondkopf der Bondstation zugeführt. In der Bondstation wird der einzelne Systemträger durch zusätzliche und auf den jeweiligen Systemträger eingestellte Schienen geführt und an den seitlichen Rändern durch weitere, damit in Eingriff bringbare Rollen positioniert und gehalten. Die Einrichtung hat den Nachteil, dass bei unterschiedlich ausgebildeten Systemträgern die Schienen jeweils neu eingestellt und justiert werden müssen, wobei zur Vermeidung von Verformungen der hochempfindlichen Systemträger die Einstellung der Führungsschienen extrem präzis sein muss. Die zusätzlichen Justierarbeiten der Schienen sind zeitund kostenaufwendig.

Die CH-A-423 397 beschreibt eine Transportvorrichtung an einer Arbeitsmaschine zum schrittweisen Vorschieben eines streifen- oder bandförmigen Werkstücks zu einer Bearbeitungsstelle, wobei das einzelne Werkstück einerseits mittels hin- und herbewegbarer, pneumatisch oder hydraulisch betätigbarer Klemmelemente der Bearbeitungsstelle zugeführt und andererseits durch ortsfeste Klemmelemente gehalten wird.

Der Erfindung liegt die Aufgabe zugrunde, ein Verfahren und eine Einrichtung zur Durchführung des Verfahrens anzugeben, mittels welchem/welcher ein exakt ausgerichteter Transport, beispielsweise ein taktartiger Transport von Systemträgern unterschiedlicher Ausgestaltungen (Typen) sowie deren Zuführung zu einer in Durchlaufrichtung entsprechend angeordneten Bearbeitungs- oder Bondstation ohne zusätzliche Umrüst- und/oder Handhabungsmassnahmen, ermöglicht wird.

Diese Aufgabe wird nach dem erfindungsgemässen Verfahren durch die Merkmale des Patentanspruchs 1 gelöst.

Die erfindungsgemässe Einrichtung zur Durchführung des Verfahrens besteht aus einer von einem elektromotorischen Antrieb (30) betätigbaren Transportvorrichtung (70) und einer zugeordneten Bearbeitungs- oder Bondstation (75), welcher mit im Abstand zueinander angeordneten Prozesspunkten und Bohrungen versehene Systemträger (1) zum Bonden elektrischer Schaltungen und/oder elektronischer Komponenten (3′) zuführbar sind, und weiterhin einem Sensor (80), mittels welchem die zur Steuerung des elektromotrischen Antriebs (30) erforderlichen Daten erfassbar sind, und ist dadurch gekennzeichnet, dass die Transportvorrichtung (70) einen in Transportrichtung (X′) orientierten Hauptträger (10) mit daran im Abstand zueinander feststehend angeordneten ersten Klemmelementen (13, 14, 15, 16, 17) sowie ein in Transportrichtung orientiertes Trägerglied (20) mit daran im Abstand zueinander angeordneten zweiten Klemmelementen (23, 24, 25, 26, 27) umfasst, wobei das Trägerglied (20) zusammen mit den die einzelnen Systemträger (1) der Bearbeitungs- oder Bondstation (75) zuführenden zweiten Klemmelementen (23 bis 27) mittels des elektromotorischen Antriebs (30) und einer damit wirkverbundenen Führungseinheit (35) relativ zu den am Hauptträger (10) angeordneten ersten Klemmelementen (13 bis 17) in Transportrichtung hin- und herbewegbar ist, und der elektromotorische Antrieb (30) durch einen Aktuator (102), der durch mittels eines Rechners (103) aus den vom Sensor (80) ermittelten Daten erzeugte Signale ansteuerbar ist, und eine Positionskontroll- und Steuereinheit (101) zur Erfassung der momentanen Stellung der in Transportrichtung (X′) verstellbaren zweiten Klemmelemente (23 bis 27) steuerbar ist.

Weitere Merkmale der Erfindung ergeben sich aus der folgenden Beschreibung in Verbindung mit der Zeichnung und den weiteren Patentansprüchen.

Die Erfindung wird nachstehend anhand der Zeichnung beschrieben. Es zeigt:
- Fig. 1: eine schematisch und in Draufsicht dargestellte Einrichtung zum Zuführen streifenartiger Werkstücke zu einer Bearbeitungs- oder Bondstation in einer ersten Stellung,
- Fig. 2: die in Draufsicht dargestellte Einrichtung gemäss Fig.1 in einer zweiten Stellung,
- Fig. 3: ein schematisch und in perspektivischer Ansicht dargestelltes Teilstück der Einrichtung gemäss Fig.1,
- Fig. 4: einen Schnitt durch die Einrichtung gemäss der Linie IV-IV in Fig.1,
- Fig. 5: ein im Schnitt dargestelltes Teilstück der Einrichtung gemäss der Linie V-V in Fig.1,
- Fig. 6: einen Schnitt durch die Einrichtung gemäss der Linie VI-VI in Fig.1,
- Fig. 7: ein Teilstück des streifenartigen Werkstücks,
- Fig. 8: ein in grösserem Massstab dargestelltes Klemmelement einer ersten Gruppe Klemmelemente für die Einrichtung gemäss Fig.1
- Fig. 9: einen in Schnittansicht dargestellten Ausschnitt des durch einen Kreis D bezeichneten vorderen Bereichs des Klemmelements gemäss Fig.8,
- Fig.10: ein in grösserem Massstab und in Schnittansicht dargestelltes Klemmelement einer zweiten Gruppe Klemmelemente für die Einrichtung gemäss Fig.1,
- Fig.11: eine in Schnittansicht dargestellte, dem einzelnen Klemmelement gemäss Fig.10 zugeordnete Positioniervorrichtung,
- Fig.12: die gemäss Pfeilrichtung B in Fig.11 in Ansicht dargestellte Positioniervorrichtung für das Klemmelement gemäss Fig.10,
- Fig.13: die gemäss Fig.11 in Draufsicht und in kleinerem Massstab dargestellte Positioniervorrichtung, und
- Fig.14: eine in Stirnansicht gemäss Pfeilrichtung C in Fig.10 dargestellte Ausführungsvariante mit den korrespondierend zueinander angeordneten Klemmflächen der Klemmelemente.

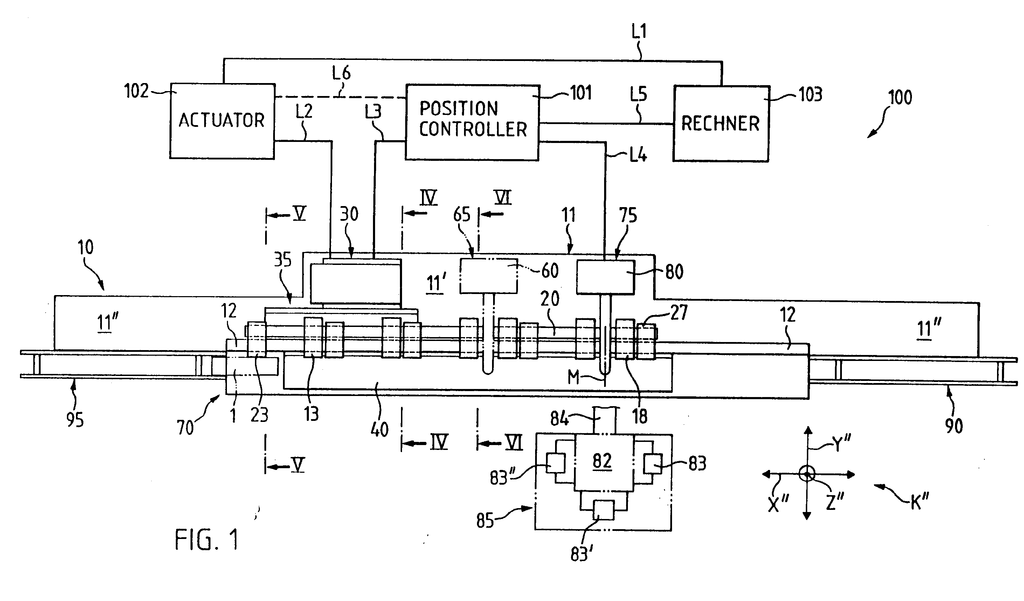

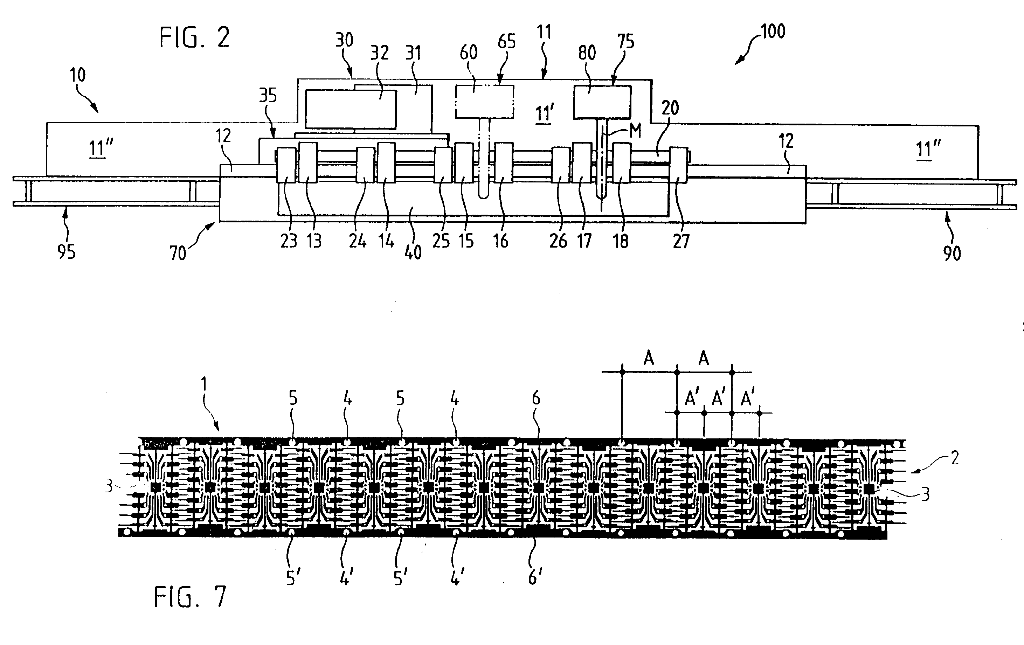

In den Figuren 1 und 2 ist zur Verdeutlichung der Erfindung als allgemeine Übersicht eine in ihrer Gesamtheit mit 100 bezeichnete Einrichtung schematisch und in Draufsicht dargestellt. Die unter anderem eine entsprechend ausgebildete und zugeordnete Transportvorrichtung 70 umfassende Einrichtung 100 ist zum Zuführen streifenartiger Werkstücke zu mindestens einer der Vorrichtung 70 entsprechend zugeordneten Bearbeitungs- oder Bondstation 75 ausgebildet. Die Station 75 ist mit einem Messorgan, beispielsweise einem schematisch dargestellten, optischen Sensor 80 versehen.

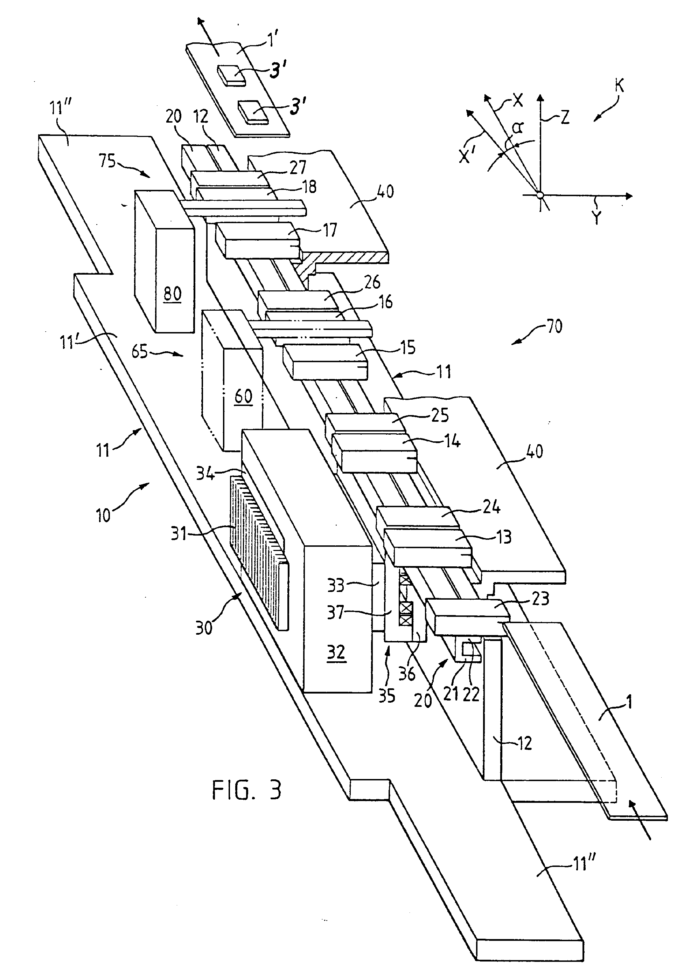

Bei der Zuführbewegung wird das einzelne Werkstück in einer ersten Phase, taktartig und etwa längs einer in einem schematisch dargestellten Koordinatensystem K (Fig. 3) mit Pfeilrichtung X und in einer zweiten Phase in der mit Pfeilrichtung X′ bezeichneten Koordinate der Bearbeitung- oder Bondstation 75 beziehungsweise dem optischen Sensor zugeführt. Bei einem bevorzugten Ausführungsbeispiel kann das Werkstück in einer dritten Phase auch gemäss einer mit Pfeilrichtung Y bezeichneten Koordinate ausgerichtet werden, wobei die Koordinate Y in der Ebene etwa rechtwinklig zu der Koordinate X′ orientiert ist. Die Mittel zur Durchführung der Zuführbewegung in Pfeilrichtung X′ und der Ausrichtbewegung in Pfeilrichtung Y werden im einzelnen noch beschrieben.

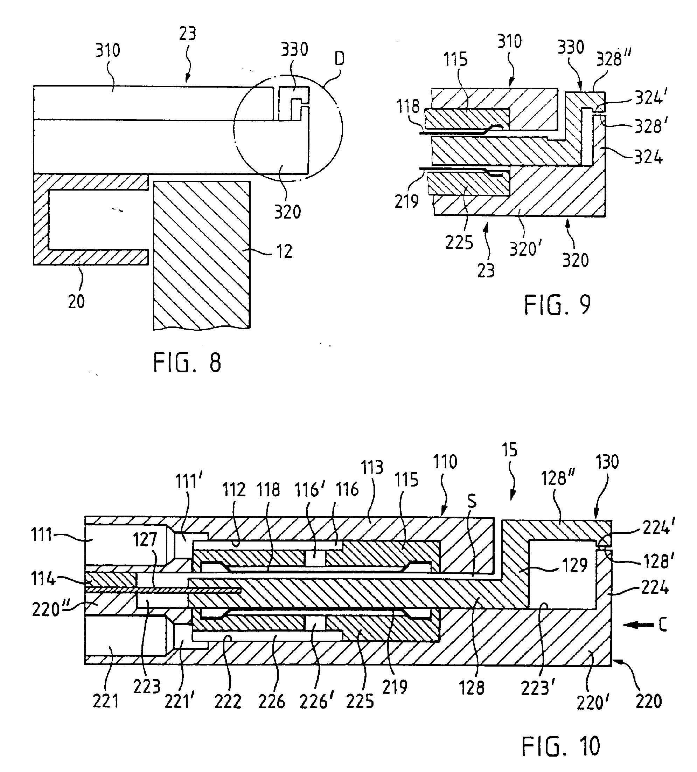

Bei dem in Fig.7 schematisch dargestellten Teilstück des Werkstücks handelt es sich beispielsweise um einen sogenannten, an sich bekannten, metallenen Systemträger 1 (leadframe strips) mit beispielsweise mehrpolig ausgebildeter Oberflächenstruktur 2 sowie mit mehreren in Reihe angeordneten Auflageflächen 3 oder Aussparungen (Prozesspunkt) zur automatischen Befestigung und Kontaktierung nicht dargestellter, elektronischer Komponenten wie Chips oder dergleichen, beziehungsweise zur Bildung integrierter Schaltkreise. Die bei der Herstellung derartiger Systemträger 1 an den Seitenrändern 6,6′ vorgesehenen und in bestimmten, periodischen Abständen A zueinander angeordneten Löcher 4,5 beziehungsweise 4′,5′ haben in bezug zu der Auflagefläche 3 einen bestimmten, mit A′ bezeichneten Abstand, welche Löcher 4,5 oder 4′,5′ in Verbindung mit der erfindungsgemässen Einrichtung 100 bei der Zuführbewegung zur Bearbeitungs- Bondstation 75 in Pfeilrichtung X′ als Referenz-Geometrie benutzt werden. Der in Fig.7 dargestellte Systemträger 1 ist ein Ausführungsbeispiel, wobei die Verwendung anderer Trägerform-Ausgestaltungen mit entsprechenden Referenz-Geometrien auch möglich ist. Die eigentliche Positionier-Funktion des Systemträgers wird später in Verbindung mit der Arbeits- und Wirkungsweise der gesamten Einrichtung 100 beschrieben.

Die in Fig.1 schematisch und in Draufsicht dargestellte Einrichtung 100 umfasst in Durchlaufrichtung, gemäss Pfeilrichtung X,X′ (Fig.3) gesehen, im wesentlichen eine an dem einen Ende angeordnete Ausgabevorrichtung 95 für die unbestückten Werkstücke oder Systemträger 1, eine an dem anderen Ende angeordnete Aufnahmevorrichtung 90 für die in Fig.1 mit nicht näher dargestellten, elektronischen Komponenten bestückten Systemträger 1 sowie die etwa zwischen den beiden Vorrichtungen 95 und 90 angeordnete Transportvorrichtung 70. Die beiden schematisch dargestellten Ausgabe- und Aufnahmevorrichtungen 95 und 90 sind beispielsweise magazinartig und in nicht näher dargestellter Weise zur übereinanderliegenden Aufnahme der einzelnen Systemträger 1 ausgebildet. Andere Ausgestaltungen der Ausgabe- und Aufnahmevorrichtungen 95,90 sind ebenfalls möglich, aber nicht Gegenstand dieser Erfindung und aus diesen Gründen nicht näher beschrieben.

Der Einrichtung 100 kann eine, in Fig.1 schematisch dargestellte, mit geeigneten elektromotorischen Antrieben 83,83′ und 83˝ versehene Vorrichtung 85 zugeordnet werden. Die Vorrichtung 85 ist zur Durchführung der Zustellbewegung eines an einem Trägerteil 82 angeordneten, teilweise und schematisch dargestellten Bondkopfes 84 zu dem mittels der Transportvorrichtung 70 der Bearbeitungs- oder Bondstation 75 zugeführten Systemträger 1 ausgebildet. Die Zustellbewegung des Trägerteils 82 erfolgt im wesentlichen gemäss dem in Fig.1 schematisch dargestellten Koordinatensystem K˝ in Pfeilrichtung X˝ und Pfeilrichtung Y˝, wobei die Zustellbewegung des teilweise dargestellten Bondkopfes 84 in Pfeilrichtung Y˝ und orthogonal dazu in Pfeilrichtung Z˝ erfolgt. Die Transportvorrichtung 70 umfasst, wie in Fig.1 und 2 schematisch und in Draufsicht sowie in Fig.3 in grösserem Massstab und in perspektivischer Ansicht dargestellt, einen in Längsrichtung, welche im wesentlichen der Transportrichtung entspricht, orientierten Hauptträger 10, ein Trägerglied 20, eine Führungseinheit 35 sowie einen mit der Führungseinheit 35 wirkverbundenen elektromotorischen Antrieb 30. Die Elemente 10,20,30 und 35 werden nachstehend im einzelnen beschrieben:

Der in der Gesamtheit mit 10 bezeichnete Hauptträger besteht im wesentlichen aus einer Grundplatte 11 und einem Steg 12, wobei die Grundplatte 11 in Längsrichtung gesehen und wie in Fig.3 deutlicher dargestellt, beispielsweise mit einem breiter ausgebildeten Mittelstück 11′ versehen ist, an welches sich in Längsrichtung gesehen an beiden Enden Teilstücke 11˝ anschliessen. Im Bereich des Mittelstücks 11′ erstreckt sich der rechtwinklig auf der Grundplatte 11 angeordnete und mit nicht dargestellten Mitteln befestigte Steg 12. Auf dem Steg 12 sind beispielsweise eine Anzahl feststehende und im Abstand zueinander angeordnete Klemmelemente 13, 14,15,16,17 und 18 vorgesehen. Der aus der Grundplatte 11 und dem Steg 12 im wesentlichen im Profilquerschnitt ⊥ -förmig ausgebildete Hauptträger 10 kann auch einstückig ausgebildet sein.

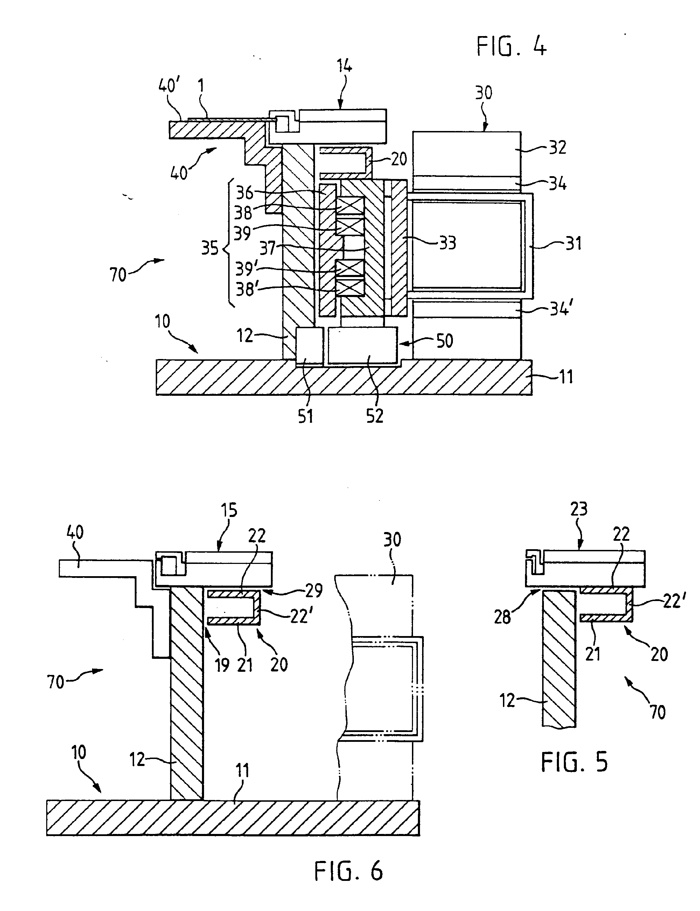

Das mit der Führungseinheit 35 in Wirkverbindung stehende Trägerglied 20 hat beispielsweise einen etwa U-förmigen Profilquerschnitt mit zwei etwa parallel zueinander angeordneten Flanschen 21 und 22 sowie einen die Flanschen 21,22 miteinander verbindenden senkrechten Steg 22′ (Fig.5,6). An dem oberen Flansch 22 sind im Abstand zueinander angeordnete und, wie in Fig.1 und 2 schematisch dargestellt, relativ zu den am Steg 12 angeordneten, feststehenden Klemmelementen 13 bis 18 zusammen mit dem Trägerglied 20 verstell- oder verschiebbare Klemmelemente 23,24,25,26 und 27 angeordnet. Das Trägerglied 20 mit den darauf oder daran befestigten Klemm elementen 23 bis 27 ist, wie im Koordinatensystem K in Fig.3 mit Pfeilrichtung X′ (Transportrichtung) angedeutet, unter einem extrem spitzen Winkel α in der Seite und in der Ebene gegenüber der mit Pfeilrichtung X bezeichneten Koordinate verstell- oder verschiebbar, wobei in der mit Pfeilrichtung X bezeichneten Koordinate die am Steg 12 des Hauptträgers 10 feststehend angeordneten Klemmelemente 13 bis 18 vorgesehen sind.

Die mit dem Trägerglied 20 wirkverbundenen Klemmelemente 23 bis 27 werden nachstehend als erste Gruppe Klemmelemente und die am Steg 12 des Hauptträgers 10 feststehend angeordneten Klemmelemente 13 bis 18 werden nachstehend als zweite Gruppe Klemmelemente bezeichnet. Die Anzahl der Klemmelemente der beiden Klemmelement-Gruppen ist variabel und kann den an die gesamte Einrichtung 100 gestellten Anforderungen entsprechend angepasst werden. Die einzelnen Klemmelemente 23 bis 27 der ersten Gruppe sowie die Klemmelemente 13 bis 18 der zweiten Gruppe sind mittels einer entspechend zugeordneten Energiequelle hydraulisch oder pneumatisch oder elektromagnetisch betätigbar.

Der spezielle Bewegungsverlauf der ersten Gruppe Klemmelemente 23 bis 27 relativ zu der zweite Gruppe Klemmelemente 13 bis 18 in Verbindung mit der Arbeitsweise der gesamten Einrichtung 100 wird später noch beschrieben.

Fig.5 zeigt in Schnittansicht gemäss der Linie V-V in Fig.1 ein Teilstück der Transportvorrichtung 70 und man erkennt den Steg 12 sowie das die beiden Flanschen 21,22 sowie den Steg 22′ umfassende Trägerglied 20 mit dem an dieser Stelle auf dem Trägerglied 20 angeordneten und mit nicht näher dargestellten Mitteln am Flansch 22 befestigten Klemmelement 23 der ersten Gruppe Klemmelemente 23 bis 27. Für die freie (berührungslos),lineare und in Pfeilrichtung X′ orientierte Transportbewegung der ersten Gruppe Klemmelemente 23 bis 27 ist, wie in Fig.5 als Beispiel dargestellt, zwischen dem Steg 12 und der dem Steg 12 zugewandten unteren Fläche des einzelnen Klemmelements 23 bis 27 ein ausreichender Spalt 28 vorgesehen.

Fig.6 zeigt in Schnittansicht gemäss der Linie VI-VI in Fig.1 die Transportvorrichtung 70 und man erkennt den Hauptträger 10 mit der Grundplatte 11 und dem Steg 12, das mit einem seitlichen Spalt 19 zum Steg 12 angeordnete Trägerglied 20 und das an dieser Stelle auf dem Steg 12 angeordnete und mit nicht dargestellten Mitteln befestigte Klemmelement 15 der zweiten Gruppe Klemmelemente 13 bis 18. Für die lineare und in Pfeilrichtung X′ orientierte Bewegung des Trägerglieds 20 ist zwischen den feststehenden Klemmelementen 13 bis 18 und dem Trägerglied 20 jeweils ein Spalt 29 vorgesehen. Weiterhin erkennt man in Fig.6 ein am Steg 12 mit nicht dargestellten Mitteln lösbar befestigtes Auflageelement 40 sowie den auf der anderen Seite angeordneten und in dieser Figur durch die strichpunktierten Linien teilweise dargestellten Antrieb 30.
Der elektromotorische Antrieb 30 hat, wie in Fig.3 in perspektivischer Ansicht teilweise dargestellt, einen mit nicht näher dargestellten Mitteln auf dem Mittelstück 11′ der Grundplatte 11 des Hauptträgers 10 befestigten Statorkörper 32 mit etwa E-förmigem Profilquerschnitt und entsprechend angeordneten Magnetteilen 34,34′ (nur das Magnetteil 34 ist hier sichtbar) sowie einen im Statorkörper 32 geführten Spulenkörper 31, welcher an einer mit der Führungseinheit 35 in Wirkverbindung stehenden Befestigungsplatte 33 mit nicht dargestellten Mitteln befestigt ist. Die einzelnen Teile 31,32 und 34,34′ des Antriebs 30 sind so ausgebildet und zueinander angeordnet, dass durch eine entsprechende Erregung, vorzugsweise durch eine gesteuerte oder geregelte Gleichstrom-Erregung des Spulenkörpers 31 eine Bewegung des Spulenkörpers 31 mit der Befestigungsplatte 33 in Pfeilrichtung X erfolgt und zusätzlich durch die besondere Ausbildung der Teile 31,32 auch eine Bewegung etwa in Pfeilrichtung Y möglich ist.

Fig.4 zeigt einen Schnitt gemäss der Linie IV-IV in Fig.1 und man erkennt die in der Gesamtheit mit 35 bezeichnete Führungseinheit, den im wesentlichen aus den Teilen 31,32 und 34,34′ gebildeten elektromotorischen Antrieb 30, das Trägerglied 20, den Hauptträger 10 mit dem seitlich daran angeordneten und mit nicht dargestellten Befestigungsmitteln am Steg 12 befestigten Auflageelement 40 sowie das an dieser Stelle angeordnete und auf dem Steg 12 befestigte Klemmelement 14 der zweiten, feststehenden Gruppe Klemmelemente 13 bis 18. Das Auflageelement 40 ist so an dem Steg 12 des Hauptträgers 10 angeordnet und befestigt, dass der von dem Klemmelement 14 gehaltene Systemträger 1 mit geringem, im µ-Bereich liegenden Abstand in bezug zu der mit 40′ bezeichneten Oberfläche des Auflageelements 40 angeordnet ist. Insbesondere im Bereich der Bondstation dient das Auflageelement 40, zum Beispiel beim Bonden als Gegenlager für den Systemträger 1.

Die Führungseinheit 35 umfasst ein erstes Lagerelement 36 und ein im Abstand dazu angeordnetes zweites Lagerelement 37. Zwischen den beiden plattenartig ausgebildeten Lagerelementen 36,37 sind entsprechende Gleitelemente 38,38′ und 39,39′, beispielsweise an sich bekannte, in einem sogenannten Käfig eingebaute Wälzlager angeordnet. Das erste Lagerelement 36 ist mit nicht dargestellten Mitteln an dem Steg 12 des Hauptträgers 10 befestigt und an dem zweiten Lagerelement 37 ist das Trägerelement 20 sowie die mit dem Spulenkörper 31 des elektromotorischen Antriebs 30 wirkverbundene Befestigungsplatte 33 befestigt.

Zur Erreichung der mit Pfeilrichtung X′ bezeichneten Zuführbewegung des Trägergliedes 20 mit der daran angeordneten ersten Gruppe Klemmelemente 13 bis 18 kann beipielsweise das eine Lagerelement 36 mit nicht dargestellten Mitteln entsprechend dem extrem spitzen Winkel α an dem Steg 12 des Hauptträgers 10 angeordnet sein. Bei einer anderen Variante kann die nicht näher bezeichnete Wälzlagerbahn des Lagerelements 36 mit einem entsprechenden Winkel α versehen sein. Wesentlich ist hierbei, dass die Führungseinheit 35 zur Erreichung der in Pfeilrichtung X′ orientierten Zuführbewegung ausgebildet ist, welche die in der Seite und Ebene gegenüber der mit Pfeilrichtung X bezeichneten Koordinate und somit die im wesentlichen horizontale Relativbewegung des Lagerelements 37 mit dem Trägerglied 20 und der ersten Gruppe Klemmelemente 13 bis 18 zu der am Steg 12 angeordneten zweiten Gruppe Klemmelemente 24 bis 27 ermöglicht.

Zum Erfassen der momentanen Stellung der mittels dem Antrieb 30 in Pfeilrichtung X′ verstellbaren Teile 37,33 und 31 in bezug zu dem Steg 12 des feststehenden Hauptträgers 10 ist im Bereich der Führungseinheit 35 und des Antriebs 30 eine entsprechend ausgebildete und in Fig.4 schematisch dargestellte Messvorrichtung 50 vorgesehen, mittels welcher in Abhängigkeit eines Ergebnisses, beispielsweise eines Vergleichs-Ergebnisses der elektromotorische Antrieb beispielsweise von einem Gleichstrom-Erregungsimpuls betätigt wird. Die Messvorrichtung 50 umfasst zwei entsprechend angeordnete Messelemente 51,52 mit nicht dargestellten Messköpfen und entsprechend zugeordneten Glas-Massstäben, welche mit in X′-Richtung orientierten Stricheinheiten versehen sind. Mittels der beispielsweise optronisch arbeitenden Messköpfe werden stellungsabhängige Daten ermittelt und in Signale umgewandelt, welche Signale dem elektromotorischen Antrieb oder einer entsprechenden Steuereinrichtung (nicht dargestellt) zugeführt werden.

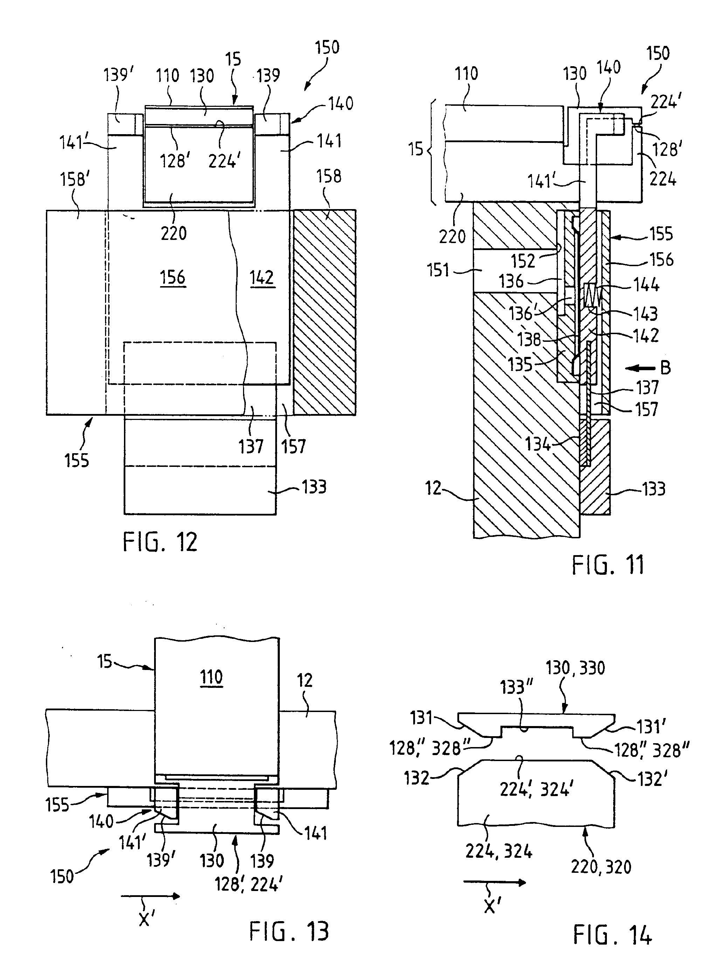

Bei einer Ausführungsvariante der Transportvorrichtung 70 ist mindestens einem der feststehenden Klemmelemente 13 bis 18 zum Ausrichten des Systemträgers 1 ein, wie in Fig.11 bis 13 dargestellt, entsprechend ausgebildetes Positionierelement 150 zugeordnet. Mit dem Positionierelement 150 wird beim Zuführen des Systemträgers 1 zu der Bearbeitungs- oder Bondstation 75, beziehungsweise zu weiteren, in Durchlaufrichtung vor oder nach der Bondstation 75 angeordneten Bearbeitungsstationen, gleichzeitig, wie im Koordinatensystem K in Fig.3 schematisch mit Pfeilrichtung Y dargestellt, eine etwa quer zur Transportrichtung X′ orientierte Ausrichtbewegung durchgeführt. Zur Erreichung einer optimalen Ausrichtung der Systemträger 1 ist jedem feststehenden Klemmelement 13 bis 18 ein Positionierelement 150 zugeordnet.

Der spezielle, konstruktive Aufbau der einzelnen Klemmelemente wird nachstehend anhand der Figuren 8 bis 10 beschrieben:

In Fig.10 ist als Ausführungsbeispiel der feststehenden Klemmelemente 13 bis 18 das Klemmelement 15 in grösserem Massstab und in Schnittansicht dargestellt und man erkennt das erste Gehäuseteil 110, welches eine Gehäusewand 113 aufweist, in welcher auf der einem Klemmkörper 130 zugewandten Innenseite eine im wesentlichen taschenartig ausgebildete Vertiefung 112 für ein Zwischenstück 115 vorgesehen ist. An dem einen Ende des Gehäuseteils 110 ist zum Anschliessen einer Mediumleitung eine entsprechend ausgebildete Öffnung 111 vorgesehen.

Das in der Vertiefung 112 des Gehäuseteils 110 angeordnete Zwischenstück 115 hat eine das Zwischenstück 115 durchdringende Bohrung 116′ sowie einen Kanal 116, welcher über eine im Gehäuseteil 110 vorgesehene Bohrung 111′ mit der Öffnung 111 in Verbindung steht. Auf der dem Klemmkörper 130 zugewandten Seite ist an dem Zwischenstück 115 ein erstes Membranteil 118 angeordnet. Das Membranteil 118 ist in einer nicht bezeichneten, im Zwischenstück 115 vorgesehenen Ausnehmung oder Vertiefung angeordnet und mit nicht dargestellten Mitteln gehalten.

Ein zweites Gehäuseteil 220 des Klemmelements 15 hat einen Boden 220′, in welchem eine erste Ausnehmung oder Vertiefung 223 sowie eine zweite Ausnehmung oder Vertiefung 222 angeordnet ist. In der zweiten, taschenartig ausgebildeten Vertiefung 222 ist ein zweites, mit einem Kanal 226 und Bohrung 226′ versehenes Zwischenstück 225 angeordnet. Der Kanal 226 steht über eine auf der einen Seite im Gehäuseteil 220 vorgesehene Bohrung 221′ mit einer entsprechend zugeordneten Öffnung 221 in Verbindung. Die Öffnung 221 ist ebenfalls, wie die Öffnung 111 im Gehäuseteil 110 zum Anschliessen der Mediumleitung ausgebildet. Auf der anderen, der Öffnung 221 gegenüberliegenden Seite des Gehäuseteils 220 ist ein Steg 224 vorgesehen, welcher auf der dem Klemmkörper 130 zugewandten Seite als erste, hier schematisch dargestellte Klemmfläche 224′ ausgebildet ist. An der dem Klemmkörper 130 zugewandten Seite ist dem Zwischenstück 225 ein zweites Membranteil 219 zugeordnet. Das Membranteil 219 ist ebenfalls in einer nicht bezeichneten, im Zwischenstück 225 vorgesehenen Ausnehmung oder Vertiefung angeordnet und mit nicht dargestellten Mitteln gehalten.

Der zwischen den beiden Gehäuseteilen 110 und 220 angeordnete Klemmkörper 130 hat einen auf der Oberfläche 223′ des Bodens 220′ aufliegenden ersten Schenkel 128, einen an dem einen Ende des Schenkels 128 angeformten, etwa senkrechten Steg 129 sowie einen am Steg 129 angeformten zweiten Schenkel 128˝. Der zweite Schenkel 128˝ ist im vorderen Bereich mit einer hier nicht näher dargestellten zweiten Klemmfläche 128′ versehen, welche mit der am Steg 224 des Gehäuseteils 220 angeordneten ersten Klemmfläche 224′ korrespondiert. Am anderen Ende des Schenkels 128 ist ein Federelement 127, beispielsweise ein federelastisch wirkender Blechstreifen oder dergleichen angeordnet und in nicht näher dargestellter Weise am Schenkel 128 befestigt. Das Federelement 127 liegt mit dem freien Ende auf einem Teilstück 220˝ des Gehäuseteils 220 und ist durch Zuordnung eines entsprechend ausgebildeten Klemmteils 114 zwischen den beiden, durch eine nicht dargestellte Schraubverbindung miteinander fest verbundenen Gehäuseteilen 110 und 220 eingeklemmt.

Unter Verwendung geeigneter Mittel, beispielsweise durch die membranartig ausgebildeten Teile 118,219 oder durch nicht dargestellte, balgartig ausgebildete Druckmittel ist der Klemmkörper 130 gegen die Rückstellkraft des Federelements 127 zwischen den beiden im vorderen Bereich im Abstand oder mit einem Spalt S zueinander angeordneten Gehäuseteilen 110 und 220 entsprechend dem Spalt oder Abstand S in Richtung der Klemmbewegung frei anhebbar beweglich, so dass die beiden Klemmflächen 224′ und 128′ durch eine entsprechende, pneumatische oder hydraulisch Betätigung des Klemmkörpers 130 zum Halten des metallenen Systemträgers 1 zusammengepresst oder aber zur Freigabe des Systemträgers 1 auseinander gedrückt werden können.

Fig.8 zeigt als Ausführungsbeispiel der ersten beweglichen Gruppe Klemmelemente 23 bis 27 das in Ansicht dargestellte Klemmelement 23 und man erkennt ein mit 310 bezeichnetes erstes Gehäuseteil, ein mit 320 bezeichnetes zweites Gehäuseteil sowie einen Klemmkörper 330. Das Klemmelement 23 ist abweichend von dem vorstehend beschriebenen Klemmelement 15 mit nicht dargestellten Mitteln lösbar auf dem in Pfeilrichtung X′ verschiebbaren Trägerglied 20 befestigt. Der konstruktive Aufbau des Klemmelements 23 gemäss Fig.8 entspricht im wesentlichen dem konstruktiven Aufbau des vorstehend anhand von Fig.10 im einzelnen beschriebenen Klemmelements 15, so dass an dieser Stelle lediglich die im vorderen Bereich liegenden konstruktiven Abweichungen des Klemmelements 23 in bezug zu dem Klemmelement 15 beschrieben werden.

In Fig.9 ist der vordere, in Fig.8 durch einen Kreis D bezeichnete Bereich des Klemmelements 23 in Schnittansicht und in grösserem Massstab dargestellt und man erkennt das erste Gehäuseteil 310 mit dem darin angeordneten Zwischenstück 115 und zugeordnetem Membranteil 118, das zweite Gehäuseteil 320 mit dem darin angeordneten Zwischenstück 225 und zugeordnetem Membranteil 219 sowie den zwischen den beiden durch eine nicht dargestellte Schraubverbindung miteinander verbundenen Gehäuseteilen 310,320 angeordneten Klemmkörper 330. Abweichend von dem Klemmelement 15 ist bei diesem Ausführungsbeispiel der Schenkel 328˝ des Klemmkörpers 330 und entsprechend der Boden 320′ des Gehäuseteils 320 kürzer ausgebildet. Weiterhin erkennt man in Fig.9 den Steg 324 mit der Klemmfläche 324′ des Gehäuseteils 320 sowie die korrespondierend dazu am Schenkel 328˝ des Klemmkörpers 330 angeordnete Klemmfläche 328′.

Der im wesentlichen auf der Arbeits- und Wirkungsweise basierende, im vorderen Bereich vorgesehene Ausgestaltungs-Unterschied der ersten Gruppe Klemmelemente 23 bis 27 in bezug zu der zweiten Gruppe Klemmelemente 13 bis 18 liegt darin, dass den feststehenden Klemmelementen 13 bis 18 der Systemträger 1 von den mobilen Klemmelementen 23 bis 27 bewusst und beabsichtigt in einer geringen, in der Seite und Ebene unter dem im µ-Bereich liegenden Winkel α versetzten Schräglage gemäss Pfeilrichtung X′ zugeführt wird und mittels der, jeweils den feststehenden Klemmelementen 13 bis 18 zugeordneten und entsprechend ausgebildeten Positioniervorrichtung 150 ausgerichtet werden muß.

Bei einem bevorzugten Ausführungsbeispiel ist den feststehenden Klemmelementen 13 bis 18 jeweils die in der Gesamtheit mit 150 bezeichnete Positioniervorrichtung zugeordnet, welche nachstehend anhand der Figuren 11 bis 13 beschrieben wird:

In Fig.11 ist in Schnittansicht die Positioniervorrichtung 150 dargestellt und man erkennt das mit nicht dargestellten Mitteln auf dem Steg 12 des Hauptträgers 10 mittels einer nicht dargestellten Schraubverbindung lösbar befestigte Klemmelement 15 mit den beiden teilweise dargestellten Gehäuseteilen 110,220 und den Klemmkörper 130.

Die Positioniervorrichtung 150 umfasst im wesentlichen ein Positionierelement 140, ein Halteteil 155, ein Zwischenstück 135 mit zugeordnetem Membranteil 138, ein Federelement 137 sowie ein Haltestück 133. Das in Fig.11 dargestellte und etwa membranartig ausgebildete Druckelement 138 kann auch in nicht näher dargestellter Weise balgartig ausgebildet sein.

Das Positionierelement 140 hat ein plattenartig ausgebildetes Teilstück 142, an welchem an dem einen Ende das beispielsweise aus einem federelastisch wirkenden Blechstreifen oder dergleichen bestehende Federelement 137 angeordnet und mit nicht dargestellten Mitteln befestigt ist. Das an einem entsprechend zugeordneten Zwischenstück 134 (Fig.11) anliegende und mit dem Positionierelement 140 wirkverbundene Federelement 137 ist mittels dem Haltestück 133 und einer nicht näher dargestellten Schraubverbindung lösbar am Steg 12 des Hauptträgers 10 befestigt. An dem anderen Ende des etwa gabelartig ausgebildeten Positionierelements 140 sind zwei im Abstand zueinander angeordnete Schenkel 141,141′ vorgesehen, zwischen welchen, wie in Fig.12 dargestellt, das Klemmelement 15 angeordnet ist. Im oberen Bereich ist an dem Schenkel 141 eine Gleitfläche 139 und an dem Schenkel 141′ eine Gleitfläche 139′ vorgesehen, wobei die beiden Gleitflächen 139,139′ kufenartig ausgebildet sind.

Das im Profilquerschnitt und in Draufsicht (Fig.13) etwa [-förmig ausgebildete Halteteil 155 hat eine Frontplatte 156, zwei im Abstand zueinander angeordnete Stege 158,158′ sowie eine zwischen den beiden Stegen 158,158′ vorgesehene Ausnehmung 157. In der in Fig.12 teilweise aufgebrochen dargestellten Stirnansicht gemäss Pfeilrichtung B in Fig.11 ist das zwischen den Stegen 158,158′ in der Ausnehmung 157 angeordnete Teilstück 142 des Positionierelements 140 dargestellt und man erkennt weiterhin das Federelement 137 sowie das Haltestück 133. An der Innenseite der Frontplatte 156 ist eine Druckfeder 144 angeordnet und mit nicht dargestellten Mitteln gehalten. Die Druckfeder 144 mit dem freien Ende in einer Ausnehmung 143 des Teilstücks 142 angeordnet und wirkt im wesentlichen auf das Positionierelement 140. Das Halteteil 155 ist vorzugsweise einstückig ausgebildet und mittels einer nicht näher dargestellten Schraubverbindung an dem Steg 12 des Hauptträgers 10 lösbar befestigt.

In dem Steg 12 ist, wie in Fig.11 dargestellt, eine taschenartig ausgebildete Ausnehmung 152 vorgesehen, in welche das mit einem Kanal 136 und Bohrung 136′ versehene Zwischenstück 135 angeordnet ist. Der Kanal 136 steht mit einer im Steg 12 vorgesehenen Bohrung 151 in Verbindung, wobei die Bohrung 151 zum Anschliessen einer nicht dargestellten Mediumleitung ausgebildet ist. Auf der dem Teilstück 142 zugewandten Seite ist, in einer nicht näher bezeichneten Ausnehmung des Zwischenstücks 135 das Membranteil 138 angeordnet und mit nicht dargestellten Mitteln gehalten.

Fig.12 zeigt die gemäss Pfeilrichtung B (Fig.11) in Ansicht und teilweise aufgebrochen dargestellte Positioniervorrichtung 150 und man erkennt im wesentlichen das zwischen den beiden Stegen 141,141′ angeordnete Klemmelement 15, das zwischen den beiden Stegen 158,158′ des Halteteils 155 in der Ausnehmung 157 angeordnete Teilstück 142 des Positionierelements 140 sowie das mit nicht dargestellten Mitteln am Steg 12 des Hauptträgers 10 (nicht dargestellt) befestigte Haltestück 133.

In Fig.13 ist die Positioniervorrichtung 150 in kleinerem Massstab und in Draufsicht dargestellt und man erkennt das Halteteil 155, den Steg 12 mit dem darauf angeordneten Klemmelement 15, welches mit dem Klemmkörper 130 zwischen den beiden kufenartig ausgebildeten Stegen 141,141′ des Positionierelements 140 angeordnet ist. Die Klemmfläche 128′ des Klemmkörpers 130 sowie die korrespondierende Klemmfläche 224′ des Gehäuseteils 220 haben, wie in Fig.13 dargestellt, in Transportrichtung X′ gesehen etwa die gleiche Breite wie das Aussenmass der beiden im Abstand zueinander angeordneten und mit den Gleitfächen 139,139′ versehenen Stege 141,141′ des Positionierelements 140.

Fig.14 zeigt in Stirnansicht gemäss Pfeilrichtung C in Fig.10 als Ausführungsvariante die mit beidseitig angeformten Gleitkufen 132,132′ versehene und am Steg 224,324 des Gehäuseteils 220,320 vorgesehene Klemmfläche 224′,324′ sowie die korrespondierende Klemmfläche des Klemmkörpers 130,330. Die Klemmfläche 128′,328′ ist bei dieser Variante in Transportrichtung gesehen durch eine Ausnehmung 131˝ in zwei Teilstücke 128˝, 328˝ unterteilt und hat beidseitig angeformte Gleitkufen 131, 131′.

An dieser Stelle sei darauf hingewiesen, dass die membranartig ausgebildeten und vorzugsweise pneumatisch oder hydraulisch ansteuerbaren Druckelemente 118,219 und 138 der Klemmelemente 23 bis 27 und 13 bis 18 sowie der Positioniervorrichtung 150 auch durch elektromagnetische, nicht dargestellte Spulenkörper unter entsprechender Ausgestaltung der Gehäuseteile ersetzt werden können.

Die Arbeitsweise der Einrichtung 100 in Verbindung mit einer Steuereinheit 101 (POSITIONS CONTROLLER), einem Actuator 102, einem Rechner 103, entsprechenden Leitungen L1,L2,L3,L4,L5 und L6, der Ausgabevorrichtung 95, der Transportvorrichtung 70 und der Aufnahmevorrichtung 90 für den einzelnen beispielsweise mit elektronischen Komponenten zu bestückenden Systemträger 1 wird nachstehend beschrieben:

Die in nicht näher dargestellter Weise beispielsweise übereinanderliegend in der in Fig.1 und 2 schematisch dargestellten Ausgabevorrichtung 95 angeordneten Systemträger 1 werden in einer ersten Phase einzeln und beispielsweise taktweise gesteuert mit nicht näher dargestellten Stösseln oder dergleichen aus der Ausgabevorrichtung 95 ausgestossen oder ausgeschoben und mit geeigneten, nicht dargestellten Mitteln vorzugsweise weitgehend ausgerichtet für die Vorschubbewegung in Pfeilrichtung X dem ersten, beweglichen Klemmelement 23 der ersten Gruppe Klemmelemente 23 bis 27.

Der von dem ersten Klemmelement 23 geklemmte und gehaltene Systemträger 1 wird nunmehr taktweise und im wesentlichen mittels der vorstehend im einzelnen beschriebenen Führungseinheit 35 in Pfeilrichtung X′, dass heisst, in bezug zur Pfeilrichtung X, in welcher die feststehenden Klemmelemente 13 bis 18 angeordnet sind, in der Seite und Ebene um den Winkel α in Pfeilrichtung X′, wie schematisch im Koordinatensystem K in Fig.3 dargestellt, der zweiten Gruppe Klemm elemente 13 bis 18 zugeführt.

Bei der taktweisen Zuführbewegung des Systemträgers 1 in Pfeilrichtung X′ werden die einzelnen Gruppen der Klemmelemente nacheinander zum Klemmen und Freigeben der nacheinander in Transport- und Pfeilrichtung X′ zu transportierenden Systemträger 1 entsprechend geschlossen und wieder geöffnet.

Die Vorschubbewegung des mit dem elektromotorischen Antrieb 30 wirkverbundenen Trägerglieds 20 und der damit wirkverbundenen ersten Gruppe Klemmelemente 23 bis 27 steht hierbei in direktem Zusammenhang mit den mit A bezeichneten Abständen von Loch 4 zu Loch 5 oder Loch 4′ zu Loch 5′ beziehungsweise der Abstände A′ von Loch 4′ oder 5′ zur Auflagefläche 3 (Prozesspunkt) des in Fig.7 als Ausführungsbeispiel dargestellten Systemträgers 1. Die Abstände A beziehungsweise A′ in bezug zur Auflage- oder Prozessfläche 3 werden als sogenannte Referenz-Geometrie verwendet und sind vom jeweiligen Systemträger abhängige Bezugsgrössen, welche als entsprechende Daten zur Steuerung des Antriebs 30 in einen entsprechend zugeordneten Actuator 102 oder dergleichen eingegeben werden. Die Vorschubbewegung ist somit von der Ausgestaltung (Lochabstand zum Prozesspunkt) des jeweiligen, mit elektronischen Komponenten oder dergleichen zu bestückenden Systemträgers 1 einstellbar, dass heisst, in Abhängigkeit von den jeweiligen Lochabständen zum Prozesspunkt in dem mit dem Antrieb 30 wirkverbundenen Actuator 102 vorprogrammierbar. Ein zeitraubender, manueller Eingriff, wie bei vergleichbaren, an sich bekannten Vorrichtungen ist somit nicht mehr erforderlich.

In der vorstehend erwähnten ersten Phase hat das erste, in Pfeilrichtung X verschiebbare Klemmelement 23 in bezug zu dem ersten, feststehenden Klemmelement 13 beziehungsweise die erste Gruppe Klemmelemente 23 bis 27 zu der zweiten Gruppe Klemmelemente 13 bis 18 etwa die in Fig.1 schematisch dargestellte Position, in welcher die einzelnen Klemmglieder der ersten Gruppe Klemmelemente 23 bis 27 in nicht näher dargestellter Weise geöffnet sind.

Anschliessend werden die nicht näher dargestellten und klemmend auf den seitlichen Rand 6 oder 6′ des Systemträgers 1 (Fig.7) wirkenden Gruppe Klemmelemente 23 bis 27 der ersten Gruppe mit nicht näher dargestellten, beispielsweise mit pneumatischen Mitteln geschlossen und die Klemmelemente 13 bis 18 der zweiten Gruppe geöffnet. Etwa gleichzeitig wird der elektromotorische Antrieb 30 für die Transportbewegung in Pfeilrichtung X′ entsprechend angesteuert, so dass der Systemträger 1 dem ersten, feststehenden und in einer nicht dargestellten Offenstellung (Klemmelemente 13 bis 18 sind geöffnet) befindlichen Klemmelement 13 zugeführt wird. In der etwa durch die feststehenden Klemmelemente 13 bis 18 begrenzten Stellung hat die mit dem Trägerglied 20 wirkverbundene erste Gruppe Klemmelemente 23 bis 27 etwa die in Fig.2 dargestellte Position, in welcher die Klemmelemente 13 bis 18 der zweiten Gruppe geschlossen und Klemmelemente 23 bis 27 der ersten Gruppe wieder geöffnet werden, so dass mittels des vorzugsweise als Linearmotor ausgebildeten Antriebs 30 das Trägerglied 20 mit den daran befestigten Klemmelementen 23 bis 27 wieder in die Grundstellung gemäss Fig.1 zurückgeführt werden kann. Die einzelnen Systemträger 1 werden wie vorstehend etwa beschrieben im wesentlichen schritt- oder taktartig, und mit geeigneten Mitteln entsprechend gesteuert der Bearbeitungs- oder Bondstation 75 zugeführt.

Die Vorschub- und Transportbewegung des Systemträgers 1 in Pfeilrichtung X′ wird in nicht näher dargestellter Weise mittels des Sensors 80, welcher mit seiner mit M bezeichneten Messachse in Durchlauf- oder Pfeilrichtung X′ im Abstand vor dem eigentlichen Prozess- oder Arbeitspunkt (Bondpunkt) angeordnet ist, die Referenz-Geometrie (Abstand A,A′ der Löcher 4′,5′ zum Prozesspunkt 3) dynamisch vermessen und aus den ermittelten Werten in einem Rechner 103 der erforderliche Vorschub errechnet und mittels entsprechender Signale der elektromotorische Antrieb 30 angesteuert. Das Vermessen der Referenz-Geometrie erfolgt vorzugsweise fortlaufend während der Vorschub- und Transportbewegung des Systemträgers 1.

Wie in Fig.1,2 und 3 schematisch dargestellt, kann der Transportvorrichtung 70 eine weitere, in Transportrichtung X′ vor der Bondstation 75 angeordnete und mit einem Sensor 60 zur optronischen Vermessung versehene Bearbeitungsstation 65 (Dispenser) zugeordnet sein, mittels welcher die Prozesspunkte 3 des Systemträgers 1 in nicht näher dargestellter Weise mit entsprechenden Mitteln (Epoxymasse oder dergleichen) vorbehandelt werden. Die Bearbeitungsstation 65 ist in Abhängigkeit von den Messergebnissen etwa in Transportrichtung zu der einen oder anderen Seite mit nicht dargestellten Mitteln verstellbar.

Die Vorbehandlung der Prozesspunkte 3 dient beispielsweise zum optimalen Kontaktieren und/oder bonden der in Fig.3 schematisch dargestellten, elektronischen Komponenten 5 auf dem Systemträger 1′. Als weitere Vorbehandlung kann mit der auch in Pfeilrichtung Y zustellbaren (Ausrichten auf den jeweiligen Systemträger) Bearbeitungsstation 65 eine Vorkontrolle, ein Absenken, Auftragen von Klebemittel oder Markieren des Prozesspunktes 3 des Systemträgers 1 durchgeführt werden.

Bei einem weiteren, nicht dargestellten Ausführungsbeispiel der Vorrichtung 70 kann in Transportrichtung X′ gesehen, hinter der Bearbeitungs- oder Bondstation 75 eine oder mehrere, entsprechend ausgebildete Bearbeitungsstation/en vorgesehen sein, bei welchen/welcher die Systemträger 1 nachkontrolliert, markiert oder an den entsprechenden Stellen geschnitten werden.

An dieser Stelle sei darauf hingewiesen, dass die vorstehend in Verbindung mit der Einrichtung 100 beschriebene Transportvorrichtung 70 mit einer entsprechend ausgebildeten und zugeordneten Station (nicht dargestellt) auch als Überprüfungs-Vorrichtung für bereits gebondete und/oder mit elektronischen Komponenten (Chips) versehene Systemträger 1 verwendet werden kann.

## Patentansprüche

1. Verfahren zum Bestücken streifenförmiger Systemträger (1) mit elektronischen Komponenten in einer Bearbeitungs- oder Bondstation, bei welchem Verfahren die streifenförmigen Systemträger, welche mit im Abstand zueinander angeordneten Prozesspunkten und Bohrungen versehen sind, mittels einer von einem elektromotorischen Antrieb betätigbaren Transportvorrichtung der Bearbeitungs- oder Bondstation zugeführt sowie klemmend gehalten und an den Prozesspunkten (3) elektrische Schaltungen und/oder die elektronischen Komponenten (3′) gebondet werden, dadurch gekennzeichnet, dass die einzelnen, streifenförmigen Systemträger (1) mittels relativ zu feststehend an einem Hauptträger (10) angeordneten ersten Klemmelementen (13, 14, 15, 16, 17) in Transportrichtung hin- und herbewegbarer und an einem Trägerglied (20) angeordneter zweiter Klemmelemente (23, 24, 25, 26, 27) der Bearbeitungs- oder Bondstation (75) zugeführt werden, und dass bei der Zuführbewegung einerseits die Istposition der hin- und herbewegbaren zweiten Klemmelemente (23, 24, 25, 26, 27) permanent erfasst und mit der Sollposition verglichen wird und andererseits auf den jeweiligen Prozesspunkt (3) sowie auf eine Referenzbohrung (4) des Systemträgers (1) bezogene Referenz-Geometrien optisch/elektronisch vermessen werden, wobei die derart ermittelten, positionsabhängigen Daten der hin- und herbewegbaren zweiten Klemmelemente (23 bis 27) sowie die geometrieabhängigen Daten der Systemträger (1) zur Steuerung des elektromotorischen Antriebes (30) verwendet werden.

2. Verfahren nach Anspruch 1, dadurch gekennzeichnet, dass die in Abhängigkeit von der Soll- und Istposition ermittelten Daten der zweiten Klemmelemente (23 bis 27) sowie die in Abhängigkeit von den Referenz-Geometrien ermittelten Daten des einzelnen Systemträgers (1) einem Aktuator (102) sowie einem Rechner (103) zur Bildung abhängiger Impulse zur Steuerung des elektromotorischen Antriebs (30) zugeführt werden.

3. Verfahren nach Anspruch 1, dadurch gekennzeichnet, dass bei der Zuführbewegung der einzelnen Systemträger (1) zu der Bearbeitungs- oder Bondstation (75) das mit den hin- und herbewegbaren zweiten Klemmelementen (23 bis 27) versehene Trägerglied (20) in bezug auf den in Transportrichtung orientierten und mit den feststehenden ersten Klemmelementen (13 bis 18) versehenen Hauptträger (10) unter einem in der Ebene liegenden Winkel (α) bewegt wird, wobei der einzelne Systemträger (1) vor dem Erreichen der Bearbeitungs- oder Bondstation (75) von mindestens einem der feststehend am Hauptträger (10) angeordneten ersten Klemmelemente (13 bis 18) durch eine relativ zu der linearen Zuführbewegung orientierte Querbewegung ausgerichtet wird.

4. Verfahren nach Anspruch 1, gekennzeichnet durch die Vereinigung folgender Merkmale, dass
a) die Systemträger (1) bei der Transportbewegung vor dem Erreichen der ersten Bearbeitungsstation (75) von mindestens einer weiteren, zweiten Bearbeitungsstation (65) optisch/elektronisch vermessen werden,
b) die Position der zweiten Bearbeitungsstation (65) in Abhängigkeit von den Messergebnissen etwa in Transportrichtung (X′) zu der einen oder anderen Seite verstellt wird,
c) die Systemträger (1) von der zweiten Bearbeitungsstation (65) in Form einer Vorkontrolle, einer Absenkung oder einer Markierung an den Prozesspunkten (3) vorbehandelt und
d) die Systemträger (1) mittels einer weiteren, der ersten Bearbeitungs- oder Bondstation (75) nachgeschalteten Bearbeitungsstation kontrolliert, markiert und/oder an den entsprechenden Stellen geschnitten werden.

5. Einrichtung zur Durchführung des Verfahrens nach Anspruch 1, bestehend aus einer von einem elektromotorischen Antrieb (30) betätigbaren Transportvorrichtung (70) und einer zugeordneten Bearbeitungs- oder Bondstation (75), welcher mit im Abstand zueinander angeordneten Prozesspunkten und Bohrungen versehene Systemträger (1) zum Bonden elektrischer Schaltungen und/oder elektronischer Komponenten (3′) zuführbar sind, und weiterhin einem Sensor (80), mittels welchem die zur Steuerung des elektromotorischen Antriebs (30) erforderlichen Daten erfassbar sind, dadurch gekennzeichnet, dass die Transportvorrichtung (70) einen in Transportrichtung (X′) orientierten Hauptträger (10) mit daran im Abstand zueinander feststehend angeordneten ersten Klemmelementen (13, 14, 15, 16, 17) sowie ein in Transportrichtung orientiertes Trägerglied (20) mit daran im Abstand zueinander angeordneten zweiten Klemmelementen (23, 24, 25, 26, 27) umfasst, wobei das Trägerglied (20) zusammen mit den die einzelnen Systemträger (1) der Bearbeitungs- oder Bondstation (75) zuführenden zweiten Klemmelementen (23 bis 27) mittels des elektromotorischen Antriebs (30) und einer damit wirkverbundenen Führungseinheit (35) relativ zu den am Hauptträger (10) angeordneten ersten Klemmelementen (13 bis 17) in Transportrichtung hin- und herbewegbar ist, und der elektromotorische Antrieb (30) durch einen Aktuator (102), der durch mittels eines Rechners (103) aus den vom Sensor (80) ermittelten Daten erzeugte Signale ansteuerbar ist, und eine Positionskontroll- und Steuereinheit (101) zur Erfassung der momentanen Stellung der in Transportrichtung (X′) verstellbaren zweiten Klemmelemente (23 bis 27) steuerbar ist.

6. Einrichtung nach Anspruch 5, dadurch gekennzeichnet, dass das mit der Führungseinheit (35) wirkverbundene Trägerglied (20) mit den daran angeordneten zweiten Klemmelementen (23 bis 27) in bezug auf einen in Transportrichtung (X′) orientierten und die ersten Klemmelemente (13 bis 18) tragenden Steg (12) des Hauptträgers (10) in der Ebene unter einem extrem spitzen, in der Grössenordnung von 0,0001 rad liegenden Winkel (a) der Bearbeitungs- oder Bondstation (75) zuführbar ist.

7. Einrichtung nach Anspruch 5, dadurch gekennzeichnet, dass mindestens einem der ersten, feststehend angeordneten Klemmelemente, beispielsweise dem einen im Bereich der Bearbeitungs- oder Bondstation (75) angeordneten Klemmelement (17), vorzugsweise jedoch sämtlichen, feststehend angeordneten Klemmelementen (13, 14, 15, 16, 17, 18), je eine elektromagnetisch oder pneumatisch oder hydraulisch betätigbare Positioniervorrichtung (150) zugeordnet ist, mittels welcher der einzelne Systemträger (1) orthogonal zur Klemmbewegung beziehungsweise quer zur Transportrichtung (X′) ausrichtbar ist.

8. Einrichtung nach Anspruch 5, dadurch gekennzeichnet, dass die einzelnen, feststehend und hin- und herbewegbaren ersten und zweiten Klemmelemente (13 bis 18 und 23 bis 27) einen zwischen einem ersten Gehäuseteil (110 oder 310) und einem mit einer Klemmfläche (224′ oder 324′) versehenen zweiten Gehäuseteil (220 oder 320) angeordneten und mit einer Klemmfläche (128′ oder 328′) versehenen, beidseitig mit Druckelementen (118,219) wirkverbundenen, elektromagnetisch oder pneumatisch oder hydraulisch betätigbaren Klemmkörper (130 oder 330) aufweist, bei welchem Klemmkörper (130,330) die Klemmfläche (128′ oder 328′) durch eine Ausnehmung (131˝) in zwei Klemmflächen-Teilstücke unterteilt und mit seitlichen Gleitkufen (131,131′) versehen ist, wobei die korrespondierende Klemmfläche (224′ oder 324′) des zweiten Gehäuseteils (220 oder 320) als ebene Fläche mit seitlichen Gleitkufen (132,132′) ausgebildet ist.

9. Einrichtung nach Anspruch 7, dadurch gekennzeichnet, dass die einzelne Positioniervorrichtung (150) mindestens ein mit einer elektrischen, pneumatischen oder hydraulischen Energiequelle wirkverbundenes und gegen die Rückstellkraft eines Federelements (137,144) quer zur Transportrichtung (X′) des Systemträgers (1) bewegbares und mit zwei im Abstand zueinander angeordneten Schenkeln (141,141′) versehenes Positionierelement (140) umfasst, bei welchem die Schenkel (141,141′) mit in Transportrichtung (X′) des Systemträgers (1) orientierten, kufenförmig ausgebildeten Gleitflächen (139,139′) versehen sind.

## Claims

1. A process for fitting strip-shaped system supports (1) with electronic components in a processing or bonding station, in which process the strip-shaped system supports, which are provided with processing points and holes at a distance from each other, are fed to the processing or bonding station by means of a transport apparatus operable by an electric motor drive and are held clamped and electrical circuits and/or the electronic components (3′) are bonded to the processing points (3), characterised in that the individual strip-shaped system supports (1) are fed to the processing or bonding station (75) by means of second clamping elements (23, 24, 25, 26, 27) which are disposed on a support member (20) and which can move back and forth in the direction of transport in relation to first clamping elements (13, 14, 15, 16, 17) which are disposed fixed on a main support (10), and that during the feeding movement firstly the actual position of the second clamping elements (23, 24, 25, 26, 27), which can be moved back and forth, is permanently determined and compared with the scheduled position, and secondly reference geometries with respect to the respective processing point (3) and with respect to a reference hole (4) of the system support (1) are measured optically/electronically, wherein the position-dependent data of the second clamping elements (23 to 27) which can be moved back and forth, which data are determined in this manner, as well as the geometry-dependent data of the system supports (1), are used for controlling the electric motor drive (30).

2. A process according to claim 1, characterised in that the data of the second clamping elements (23 to 27), which are determined depending on the actual and scheduled position, and the data of the individual system support (1), which are determined depending on the reference geometries, are fed to an actuator (102) and to a computer (103) for the formation of dependent pulses for controlling the electric motor drive (30).

3. A process according to claim 1, characterised in that during the feeding movement of the individual system supports (1) to the processing or bonding station (75) the support member (20) which is provided with the second clamping elements (23 to 27) which can move back and forth is moved at a horizontal angle (α) in relation to the main support (10) which is oriented in the direction of transport and which is provided with the fixed, first clamping elements (13 to 18), wherein before it reaches the processing or bonding station (75) the individual system support (1) is aligned by at least one of the fixed, first clamping elements (13 to 18) disposed fixed on the main support (10) by means of a movement oriented transversely to the linear feeding movement.

4. A process according to claim 1, characterised by the combination of the following features, that
a) the system supports (1) are measured optically/electronically during the transport movement before reaching the first processing station (75) by at least one further second processing station (65),
b) the position of the second processing station (65) is adjusted to one side or the other approximately in the direction of transport (X′) depending on the measured results,
c) the system supports (1) are pretreated by the second processing station (65) in the form of a pre-inspection, lowering, or marking at the processing points (3), and
d) the system supports (1) are inspected, marked, and/or cut at the corresponding points by means of a further processing station disposed downstream of the first processing or bonding station (75).

5. A device for carrying out the process according to claim 1, consisting of a transport apparatus (70) which can be operated by an electric motor drive (30) and an associated processing or bonding station (75) to which system supports (1) provided with processing points and holes at a distance from each other can be fed for bonding electrical circuits and/or electronic components (3′), and further consisting of a sensor (80) by means of which the data required for controlling the electric motor drive (30) can be determined, characterised in that the transport apparatus (70) comprises a main support (10) oriented in the direction of transport (X′) with first clamping elements (13, 14, 15, 16, 17) disposed fixed thereon at a distance from each other and a support member (20) oriented in the direction of transport and having second clamping elements (23, 24, 25, 26, 27) disposed thereon at a distance from each other, wherein the support member (20) together with the second clamping elements (23 to 27) feeding the individual system supports (1) to the processing or bonding station (75) can be moved back and forth in the direction of transport in relation to the first clamping elements (13 to 17) disposed on the main support (10) by means of the electric motor drive (30) and a guide unit (35) actively connected thereto, and the electric motor drive (30) can be controlled by an actuator (102) which can be triggered by signals generated from the data determined by the sensor (80) by means of a computer (103), and by a positional inspection and control unit (101) for determining the instantaneous position of the second clamping elements (23 to 27) which can be adjusted in the direction of transport (X′).

6. A device according to claim 5, characterised in that the support member (20) which is actively connected to the guide unit (35) can be fed, with the second clamping elements (23 to 27) disposed thereon, to the processing or bonding station (75) at an extremely acute horizontal angle (α) of the order of 0.0001 rad in relation to a rib (12) of the main support (10), which rib is oriented in the direction of transport (X′) and carries the first clamping elements (13 to 18).

7. A device according to claim 5, characterised in that an electromagnetically or pneumatically or hydraulically operable positioning apparatus (150) is associated in each case with at least one of the first, fixed clamping elements, for example the clamping element (17) disposed in the region of the processing or bonding station (75), but preferably with all of the fixedly disposed clamping elements (13, 14, 15, 16, 17, 18), by means of which positioning apparatus the individual system support (1) can be aligned orthogonally to the clamping movement or transversely to the direction of transport (X′).

8. A device according to claim 5, characterised in that the individual first and second clamping elements (13 to 18 and 23 to 27) which are fixed and which can move back and forth, respectively, comprise an electromagnetically or pneumatically or hydraulically operable clamping body (130 or 330) which is provided with a clamping face (128′ or 328′), which is actively connected on both sides to pressure elements (118, 219), and which is disposed between a first housing part (110 or 310) and a second housing part (220 or 320) provided with a clamping face (224′ or 324′), in which clamping body (130, 330) the clamping face (128′ or 328′) is subdivided by a recess (131˝) into two clamping face portions and is provided with lateral sliding runners (131, 131′), wherein the corresponding clamping face (224′ or 324′) of the second housing part (220 or 320) is constructed as a flat surface with lateral sliding runners (132, 132′).

9. A device according to claim 7, characterised in that the individual positioning apparatus (150) comprises at least one positioning element (140) which is actively connected to an electrical, pneumatic or hydraulic energy source, which can move transversely to the direction of transport (X′) of the system support (1) against the restoring force of a spring element (137, 144), and which is provided with two limbs (141, 141′) disposed at a distance from each other, in which positioning element the limbs (141, 141′) are provided with sliding surfaces (139, 139′) constructed in the shape of runners and oriented in the direction of transport (X′) of the system support (1).

## Revendications

1. Procédé pour l'équipement de porte-système (1) sur bande avec des composants électroniques dans un poste de traitement ou de bonding, procédé dans lequel les porte-système sur bande, qui sont munis de points de processus et de perçages à distance les uns des autres, sont amenés et maintenus par serrage à un poste de bonding ou de traitement au moyen d'un dispositif de transport actionnable par un entraînement électrique motorisé pour que des circuits et/ou des composants (3′) subissent le bonding aux points de processus (3), caractérisé en ce que les différents porte-système sur bande (1) sont amenés aux seconds éléments de serrage (23, 24, 25, 26, 27) du poste de bonding et de traitement (75), qui effectuent un mouvement de va-et-vient dans le sens de transport et qui sont fixés sur un organe porteur (20), au moyen de premiers élements de serrage (13, 14, 15, 16, 17) disposés fixement sur un support principal (10), et en ce que, pendant le mouvement d'avance, d'une part, la position effective des seconds éléments de serrage (23, 24, 25, 26, 27) mobiles en va-et-vient est relevée en permanence et est comparée avec la position théorique et, d'autre part, des géométries de référence relatives à un point de processus considéré (3) et à un perçage de référence (4) du porte-système (1) sont mesurées opto-électroniquement, les données ainsi déterminées et dépendant de la position des seconds éléments de serrage (23 à 27) mobiles en va-et-vient et les données dépendant de la géométrie du porte-système (1) sont utilisées pour la commande de l'entraînement électrique à moteur (30).

2. Procédé selon la revendication 1, caractérisé en ce que les données déterminées en fonction de la position effective et théorique des seconds éléments de serrage (23 à 27) ainsi que les données déterminées en fonction des géométries de référence des différents porte-système (1) sont transmises à un activateur (102) et à un ordinateur (103) pour la formation d'impulsions dépendantes servant à la commande de l'entraînement électrique à moteur (30).

3. Procédé selon la revendication 1, caractérisé en ce que pendant le mouvement d'avance des porte-système (1) en direction du poste de bonding ou de traitement (75), l'organe porteur (20), muni des seconds éléments de serrage (23 à 27) mobiles en va-et-vient, est déplacé par rapport au support principal (10) muni des premiers éléments de serrage fixe (13 à 18) et orienté dans le sens du transport suivant un angle (α) se trouvant dans le plan, le porte-système (1) étant aligné avant d'atteindre le poste de bonding ou de traitement (75) par au moins l'un des premiers éléments de serrage (13 à 18) disposé fixe sur le support principal (10) en effectuant un mouvement transversal orienté par rapport au mouvement d'avance linéaire.

4. Procédé selon la revendication 1, caractérisé par la réunion des caractéristiques suivantes :
a) les porte-système (1) peuvent être mesurés pendant le mouvement de transport avant d'atteindre le premier poste de traitement (75) par au moins un autre second poste de traitement (65) de manière opto-électronique,
b) la position du second poste de traitement (65) est déplacée d'un côté ou de l'autre en fonction des résultats de mesure dans le sens de transport (X′),
c) les porte-système (1) sont prétraités par le second poste de traitement (65) par un contrôle préalable, un abaissement ou un marquage au niveau des points de processus (3) et
d) les porte-système (1) peuvent être contrôlés, marqués et/ou coupés aux endroits correspondants au moyen d'un autre poste de traitement placé après le poste de traitement ou de bonding (75).

5. Dispositif pour la mise en oeuvre du procédé selon la revendication 1, se composant d'un dispositif de transport (70) actionnable par un entraînement électrique à moteur (30) et d'un poste de traitement ou de bonding (75) associé auquel sont amenés des porte-système (1) munis de perçages et de points de processus disposés à distance les uns des autres pour le bonding de circuits électriques et/ou de composants électroniques (3′) et, en outre, d'un capteur (80) au moyen duquel les données nécessaires à la commande de l'entraînement électrique à moteur (30) peuvent être saisies, caractérisé en ce que le dispositif de transport (70) comprend un support principal (10) orienté dans le sens de transport (X′) et comportant des premiers éléments de serrage (13, 14, 15, 16, 17) disposés fixement à distance les uns des autres, ainsi qu'un organe porteur (20) orienté dans le sens de transport et comportant des seconds éléments de serrage (23, 24, 25, 26, 27) disposés à distance les uns des autres, l'organe porteur (20), ensemble avec les seconds éléments de serrage (23 à 27) amenant les porte-système (1) au poste de traitement ou de bonding (75), effectue, dans le sens de transport, un mouvement de va-et-vient au moyen de l'entraînement électrique à moteur (30) et d'une unité de guidage (35) reliée activement à ce dernier et, ce, par rapport aux premiers éléments de serrage (13 à 17) disposés sur le support principal (10), et en ce que l'entraînement électrique à moteur (30) peut être commandé par un activateur (102) commandé par des signaux émis par un ordinateur (103) à partir des données transmises par le capteur (80) et par une unité de commande et de contrôle de position (101) pour la saisie de la position momentanée des seconds éléments de serrage (23 à 27) mobiles dans le sens de transport (X′).

6. Dispositif selon la revendication 5, caractérisé en ce que l'organe porteur (20), relié activement à l'unité de guidage (35) et comprenant les seconds éléments de serrage (23 à 27), peut être amené au poste de traitement ou de bonding (75) par rapport à une traverse (12) du support principal (10), portant les premiers éléments de serrage (13 à 18) et orientée dans le sens de transport (X′) et, ce, dans le plan suivant un angle (α) extrêmement aigu de l'ordre de 0,0001 degré.

7. Dispositif selon la revendication 5, caractérisé en ce qu'au moins l'un des éléments de serrage fixe, par exemple l'élément de serrage (17) disposé dans la zone du poste de traitement ou de bonding (75), de préférence, cependant tous les éléments de serrage (13, 14, 15, 16, 17, 18) disposés fixement sont associés à un dispositif de positionnement (150) actionnable électromagnétiquement, pneumatiquement ou hydrauliquement, au moyen duquel le porte-système (1) peut être aligné de manière orthogonale par rapport au mouvement de serrage respectivement transversalement au dispositif de transport (X′).

8. Dispositif selon la revendication 5, caractérisé en ce que les premiers et seconds éléments de serrage fixes et mobiles en va-et-vient (13 à 18 et 23 à 27) présentent un corps de serrage (130 ou 330) actionnable pneumatiquement, hydrauliquement ou électromagnétiquement, relié activement des deux côtés à des éléments de pression (118, 219), muni d'une surface de serrage (128′ ou 328′) et disposé entre une première partie de boîtier (110 ou 310) et une seconde partie de boîtier (220 ou 320) munie d'une surface de serrage (224′ ou 324′), corps de serrage (130, 330) dont la surface de serrage (128′, 328′) est divisée par un évidement (131˝) en deux parties de surfaces de serrage et est munie de patins latéraux (131, 131′), la surface de serrage correspondante (224′ ou 324′) de la seconde partie de boîtier (220 ou 320) étant une surface plane munie de patins latéraux (132, 132′).

9. Dispositif selon la revendication 7, caractérisé en ce que le dispositif de positionnement (150) comprend au moins un élément de positionnement (140) qui est muni de deux arcades (141, 141′) disposées à distance l'une de l'autre, qui est mobile à l'encontre de la force de rappel d'un élément de ressort (137, 144) transversalement au sens de transport (X′) du porte-système (1) et qui est relié activement à une source d'énergie électrique, pneumatique ou hydraulique, élément dont les arcades (141, 141′) sont munies de surfaces de glissement (139, 139′) en forme de patins orientés dans le sens de transport (X′) du porte-système (1).
